(19) **Europäisches Patentamt / European Patent Office / Office européen des brevets**

(11) **EP 3 352 315 B1**

(12) **EUROPEAN PATENT SPECIFICATION**

(45) Date of publication and mention
of the grant of the patent:
**15.05.2019 Bulletin 2019/20**

(51) Int Cl.:
*H02H 1/00* *(2006.01)*  *G01R 31/40* *(2014.01)*
*G01R 31/02* *(2006.01)*

(21) Application number: **17197006.4**

(22) Date of filing: **18.10.2017**

(54) **ARC DETECTION APPARATUS**

BOGENDETEKTIONSVORRICHTUNG

APPAREIL DE DÉTECTION D'ARC

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.01.2017 JP 2017009506**

(43) Date of publication of application:
**25.07.2018 Bulletin 2018/30**

(73) Proprietor: **Omron Corporation
Kyoto-shi, Kyoto 600-8530 (JP)**

(72) Inventors:
• **TOMITA, Kohei
Kyoto-shi, Kyoto 600-8530 (JP)**
• **ASHIDA, Takeshi
Kyoto-shi, Kyoto 600-8530 (JP)**

(74) Representative: **Horn Kleimann Waitzhofer
Patentanwälte PartG mbB
Ganghoferstrasse 29a
80339 München (DE)**

(56) References cited:
**EP-A2- 2 621 045  WO-A1-2010/140055**

**Description**

CROSS-REFERENCES TO RELATED APPLICATIONS

This application claims priority to Japanese Patent Application No. 2017-009506, filed January 23, 2017, the entire contents of which are incorporated herein by reference.

FIELD

The present invention relates to an arc detection apparatus that is applied to a DC power system.

BACKGROUND

Conventionally, solar power generation systems are configured such that electric power generated by a solar battery is supplied to an electric power distribution grid via a power conditioning system (hereinafter, simply referred to as a PCS) that includes an DC-AC converter and the like. In such solar power generation systems, there are cases where an arc is generated due to a malfunction of a circuit or the like in the system. If an arc is generated, the temperature of the portion in which the arc is generated becomes high, and there is a risk that a fire or the like will be caused. In view of this, the solar power generation systems are provided with an arc detection apparatus for detecting generation of an arc by measuring the alternating current of the arc using an electric current sensor.

In the configuration described in JP 2014-509396T, electric power generated by a solar battery (photovoltaic generator) is supplied to an inverter via a DC power line. The DC power line is provided with an electric current sensor, and whether or not an arc has been generated is detected based on an electric current measured by this electric current sensor.

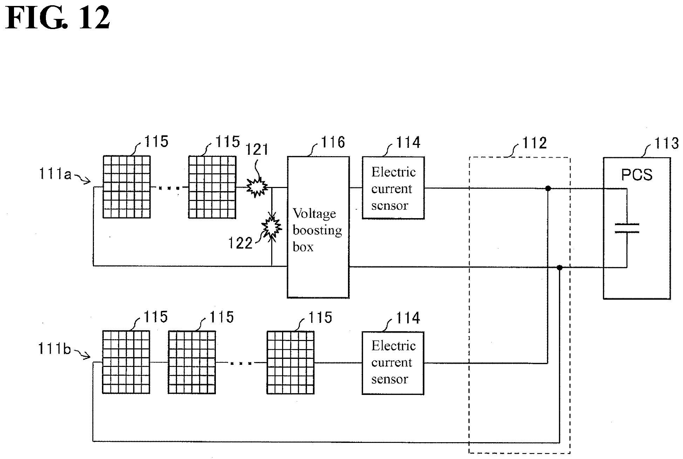

On the other hand, in a solar power generation system provided with a plurality of solar battery strings, those solar battery strings are connected in parallel in a connection box 112, and are connected to a PCS 113 via the connection box 112, as shown in FIG. 12. Also, solar battery strings 111a and 111b are each formed by connecting a plurality of solar battery modules 115 in series.

Here, for example, as shown in FIG. 12, if the number of the solar battery modules 115 of the solar battery string 111a is smaller than the number of the solar battery modules 115 of the solar battery string 111b, a voltage boosting box 116 is provided between the solar battery string 111a and the connection box 112. JP 03562118 discloses a power supply apparatus G as the voltage boosting box 116. The voltage boosting box 116 is provided with a voltage boosting circuit for boosting an output voltage of the solar battery string 111a so as to match an output voltage of the solar battery string 111b.

JP 2014-509396T and JP 03562118 are examples of background art.

SUMMARY

However, as shown in FIG. 12, if an electric arc, which is a series arc 121 or a parallel arc 122, is generated in the solar battery string 111a provided with the voltage boosting box 116, an electric current sensor 114 cannot detect the alternating current of the electric arc. This is because the voltage boosting box 116 is normally constituted by a boost chopper circuit, and the AC component of the electric arc is reduced by an inductor in the boost chopper circuit, and also because the high frequency component of the alternating current of the electric arc flows to a capacitor that is inserted into the boost chopper circuit in order to stabilize the voltage, and does not flow to the electric current sensor 114.

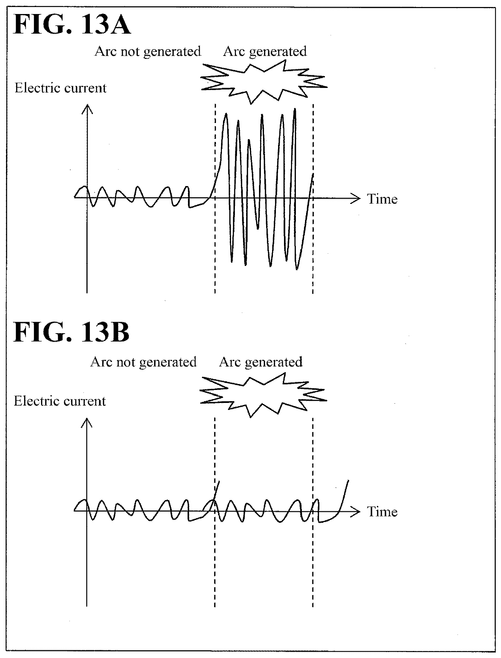

The waveforms of the alternating current before and after the voltage boosting box 116 in this case and the operation of the voltage boosting box 116 will be as shown in FIGS. 13A and 13B. FIG. 13A is a graph showing the waveforms of an alternating current in an arc non-generation state and an arc generation state upstream of the voltage boosting box 116 (on the solar battery string 111a side). FIG. 13B is a graph showing the waveforms of an alternating current in the arc non-generation state and the arc generation state downstream of the voltage boosting box 116 (on the connection box 112 side).

Although the high frequency component of the electric current increases if an arch is generated as shown in FIG. 13A, the increased high frequency component is reduced by the voltage boosting box 116. As a result, as shown in FIG. 13B, the high frequency component of the electric current caused by the arc cannot be measured by the electric current sensor 114.

Therefore, it is an object of one aspect of the present invention to provide an arc detection apparatus that can detect an electric arc generated in a DC power system such as a solar power generation system even if there is a DC-DC conversion circuit such as a voltage boosting box (a voltage boosting circuit).

In order to solve above-described problem, an arc detection apparatus according to one aspect of the present invention is applied to a DC power system including a first DC power source that generates electric power or performs charging/discharging, a DC-DC conversion circuit that converts an output voltage of the first DC power source, a load apparatus that consumes or converts an output power of the DC-DC conversion circuit, a pair of first power lines that connect the first DC power source and the DC-DC conversion circuit, and a pair of second power lines that connect the DC-DC conversion circuit and the load apparatus, the arc detection apparatus having a first capacitor whose one end portion is connected to one of the pair of first power lines, and whose other end portion is connected to one of the pair of second power lines, an electric current measurement unit that measures an electric current on the second power lines, and an arc determination unit that determines whether or not an arc is generated based on a high frequency component of an alternating current measured by the electric current measurement unit, and an impedance of the first capacitor satisfying a condition that a combined impedance of the impedance of the first capacitor, impedances of the DC-DC conversion circuit between the pair of first power lines and the pair of second power lines, an impedance of the DC-DC conversion circuit between the pair of second power lines, and an impedance of the load apparatus is smaller than an impedance of the DC-DC conversion circuit between the pair of first power lines.

According to the above-described configuration, the first DC power source is connected to the load apparatus via the first power lines, the DC-DC conversion circuit, and the second power lines, the first capacitor forms a first bypass current path that bypasses the DC-DC conversion circuit, and the electric current measurement unit measures an electric current on the second power lines. The impedance of the first capacitor satisfies the above condition, and thus an amount of alternating current that flows between the pair of first power lines via the DC-DC conversion circuit, the first capacitor, the second power lines, and the load apparatus is larger than an amount of alternating current that flows between the pair of first power lines via the DC-DC conversion circuit.

Therefore, even if there is a DC-DC conversion circuit, the electric current measurement unit on the second power lines can measure the alternating current of an arc generated in a first DC power source. Accordingly, even if there is a DC-DC conversion circuit in the DC power system, the arc detection apparatus can detect an arc generated in the DC power system.

In the arc detection apparatus according to the above aspect, a first coil may be further provided between a connection portion of the first power line connecting to the first capacitor and an input portion of the DC-DC conversion circuit. In this case, an amount of alternating current that flows through the first bypass current path increases, and an amount of alternating current that flows through the electric current measurement unit increases. As a result, an arc generated in the DC power system can be detected accurately. Note that the first coil may be provided inside the DC-DC conversion circuit, or may be provided outside of the DC-DC conversion circuit.

Incidentally, for example, if the DC-DC conversion circuit is an isolated circuit, impedances between the pair of first power lines and the pair of second power lines in the DC-DC conversion circuit are large, and an alternating current tends not to flow.

In view of this, a second capacitor whose one end portion is connected to the other of the pair of first power lines, and whose other end portion is connected to the other of the pair of second power lines is further provided, and impedances of the first capacitor and the second capacitor may satisfy a condition that a combined impedance of the impedances of the first capacitor and the second capacitor, the impedances of the DC-DC conversion circuit between the pair of first power lines and the pair of second power lines, the impedance of the DC-DC conversion circuit between the pair of second power lines, and the impedance of the load apparatus is smaller than the impedance of the DC-DC conversion circuit between the pair of first power lines.

In this case, the second capacitor forms a second bypass current path that bypasses the DC-DC conversion circuit. The impedances of the first capacitor and the second capacitor satisfy the above condition, and thus even if the impedances between the pair of first power lines and the pair of second power lines are large, the electric current measurement unit on the second power lines can measure the alternating current of an arc generated in the first DC power source. Accordingly, the arc detection apparatus can detect an arc generated in the DC power system, even if there is a DC-DC conversion circuit in the DC power system.

In the arc detection apparatus according to the above aspect, a second coil may be further provided between a connection portion on the first power line connecting to the second capacitor and the input portion of the DC-DC conversion circuit. In this case, an amount of alternating current that flows through the second bypass current path is large, and an amount of alternating current that flows through the electric current measurement unit is large. As a result, an arc generated in the DC power system can be detected accurately. Note that the second coil may be provided in the DC-DC conversion circuit, or may be provided outside of the DC-DC conversion circuit.

In the arc detection apparatus according to the above aspect, the DC power system to which the arc detection apparatus is applied may further includes a second DC power source that generates electric power or performs charging/discharging, and a pair of third power lines that connect the second DC power source and the pair of second power lines, and the electric current measurement unit may be provided between the load apparatus and one of branch points at which the pair of second power lines and the pair of third power lines are connected.

In this case, it suffices for the DC power system to have one electric current measurement unit, and does not need to have a plurality of electric current measurement units. Therefore, the arc detection apparatus can detect generation of an arc in one of the first DC power source and the second DC power source, using a simple configuration in which the electric current measurement unit is provided on the second power lines between the branch point and the load apparatus.

Note that if the second DC power source is connected to the third power lines via the DC-DC conversion circuit, it is desirable that a capacitor constituting a bypass current path that bypasses the DC-DC conversion circuit is provided similarly to on the first DC power source side, and that an impedance of the capacitor satisfies the above-described condition. The same applies to a case where the DC power system is further provided with a DC power source.

According to one aspect of the present invention, the first capacitor forms the first bypass current path that bypasses the DC-DC conversion circuit, and an impedance of the first capacitor satisfies a predetermined condition, whereby, even if there is a DC-DC conversion circuit in the DC power system, the electric current measurement unit on the second power lines can measure the alternating current of an arc generated in the first DC power source, and thus the arc detection apparatus can detect an arc generated in the DC power system.

## BRIEF DESCRIPTION OF THE DRAWINGS

FIG. 1 is a schematic circuit diagram showing the configuration of a solar power generation system provided with an arc detection apparatus according to one embodiment of the present invention.

FIG. 2 is a block diagram showing the configuration of an arc detection processing unit of the arc detection apparatus provided in the above solar power generation system.

FIG. 3A is a graph showing the waveform of an alternating current in an arc non-generation state and an arc generation state upstream of a DC-DC converter in the above solar power generation system, and FIG. 3B is a graph showing the waveform of an alternating current in the arc non-generation state and the arc generation state downstream of the above DC-DC converter.

FIG. 4A is a waveform chart showing the waveform after FFT processing of an electric current measured by an electric current sensor in the above arc detection apparatus if an arc has not been generated, in the above solar power generation system, and FIG. 4B is a waveform chart showing the waveform after FFT processing of an electric current measured by the above electric current sensor if an arc has been generated, in the above solar power generation system.

FIG. 5 is a circuit diagram similar to FIG. 1, and shows a circuit diagram showing an internal impedance of the above-described DC-DC converter and an internal impedance on the input side of a PCS in the above solar power generation system, using an equivalent circuit.

FIG. 6 is a schematic circuit diagram showing the configuration of a solar power generation system provided with an arc detection apparatus according to another embodiment of the present invention.

FIG. 7 is a schematic circuit diagram showing the configuration of a solar power generation system provided with an arc detection apparatus according to yet another embodiment of the present invention.

FIG. 8 is a schematic circuit diagram showing the configuration of a solar power generation system provided with an arc detection apparatus according to yet another embodiment of the present invention.

FIG. 9 is a schematic circuit diagram showing the configuration of a solar power generation system provided with an arc detection apparatus according to yet another embodiment of the present invention.

FIG. 10 is a schematic circuit diagram showing the configuration of a solar power generation system provided with an arc detection apparatus according to yet another embodiment of the present invention.

FIG. 11 is a schematic circuit diagram showing the configuration of a solar power generation system provided with an arc detection apparatus according to another embodiment of the present invention.

FIG. 12 is a schematic circuit diagram showing the configuration a solar power generation system provided with a conventional arc detection apparatus.

FIG. 13A is a graph showing the waveform of an alternating current in an arc non-generation state and an arc generation state upstream of a voltage boosting box in the above solar power generation system, and FIG. 13B is a graph showing the waveform of an alternating current in the arc non-generation state and the arc generation state downstream of the voltage boosting box.

## DETAILED DESCRIPTION

Embodiments of the present invention will be described below in detail. Note that for convenience of description, the same reference numerals are assigned to constituent members that have the same function as those described in the embodiments, and the description thereof is omitted as appropriate.

First Embodiment

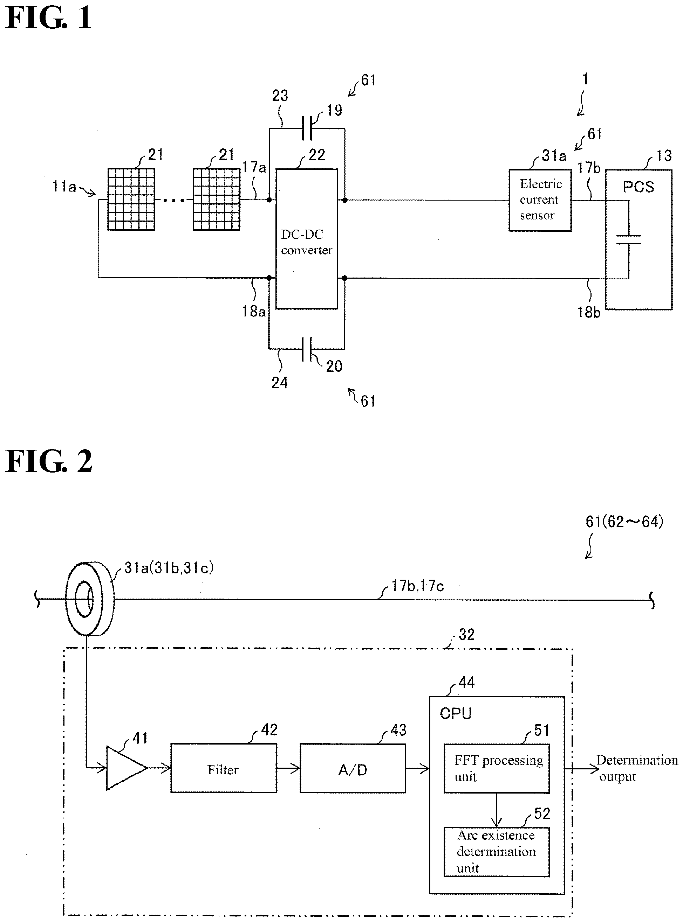

FIG. 1 is a schematic circuit diagram showing the configuration of a solar power generation system provided with an arc detection apparatus according to one embodiment of the present invention. FIG. 2 is a block diagram showing the configuration of an arc detection processing unit of the arc detection apparatus provided in the solar power generation system shown in FIG. 1.

Configuration of solar power generation system 1

As shown in FIG. 1, a solar power generation system 1 (a DC power system) is provided with a solar battery string 11a (a first DC power source), a DC-DC converter 22 (a DC-DC conversion circuit) and a power conditioning system (hereinafter, referred to as a PCS) 13 (a load apparatus).

The solar battery string 11a is formed by connecting a large number of solar battery modules 21 in series. The solar battery modules 21 each have a plurality of solar battery cells (not illustrated) connected in series, and are formed in a panel shape.

The solar battery string 11a is connected to the DC-DC converter 22 through a P-side power line 17a and an N-side power line 18a, which are a pair of power conducting paths (first power lines), and the DC-DC converter 22 is connected to the PCS 13 through a P-side power line 17b and an N-side power line 18b, which are a pair of power conducting paths (second power lines). The DC-DC converter 22 converts a direct current voltage from the solar battery string 11a into an appropriate direct current voltage, and is provided with a DC-DC conversion circuit such as a voltage boosting circuit or a step-down circuit. Output power of the DC-DC converter 22 is input to the PCS 13.

The PCS 13 converts, into alternating current power, the direct current power that has been input from the solar battery string 11a via the DC-DC converter 22, and outputs the alternating current power. Note that a load apparatus that consumes the direct current power may be provided in place of the PCS 13.

Configuration of Arc Detection Apparatus

The solar power generation system 1 is provided with an arc detection apparatus 61. The arc detection apparatus 61 is provided with bypass current paths 23 and 24, capacitors 19 and 20, an electric current sensor 31a (an electric current measurement unit) and an arc detection processing unit 32 (an arc determination unit) (see FIG. 2).

A first end portion, which is one end portion of the bypass current path 23, is connected to the power line 17a (one of the pair of first power lines) between the DC-DC converter 22 and the solar battery string 11a, and a second end portion, which is the other end portion of the bypass current path 23, is connected to the power line 17b (one of the pair of second power lines) between the DC-DC converter 22 and the PCS 13, so as to bypass the DC-DC converter 22.

The capacitor 19 (a first capacitor) is provided on the bypass current path 23. Specifically, a first electrode of the capacitor 19 is connected to the power line 17a, and a second electrode of the capacitor 19 is connected to the power line 17b, so as to form the bypass current path 23. Note that the electrostatic capacitance (an impedance) of the capacitor 19 will be described later.

A first end portion, which is one end portion of the bypass current path 24, is connected to the power line 18a (the other of the pair of first power lines) between the DC-DC converter 22 and the solar battery string 11a, and a second end portion, which is the other end portion of the bypass current path 24, is connected to the power line 18b (the other of the pair of second power lines) between the DC-DC converter 22 and the PCS 13, so as to bypass the DC-DC converter 22.

A capacitor 20 (a second capacitor) is provided on the bypass current path 24. Specifically, a first electrode of the capacitor 20 is connected to the power line 18a, and a second electrode of the capacitor 20 is connected to the power line 18b, so as to form the bypass current path 24. Note that the electrostatic capacitance (an impedance) of the capacitor 20 will be described later.

The electric current sensor 31a measures an alternating current that has been caused by an arc generated in the solar battery string 11a, and that flows from the power line 17a to the power line 17b via the bypass current path 23. Note that the electric current sensor 31a may be provided on the power line 18b. In this case, the electric current sensor 31a will measure an alternating current caused by such an arc that flows from the power line 18a to the power line 18b via the bypass current path 24.

The arc detection processing unit 32 has a conventionally known configuration, and is provided with an amplifier 41, a filter 42, an A/D conversion unit 43 and a CPU (central processing unit) 44 as shown in FIG. 2, for example.

The amplifier 41 amplifies an electric current measured by the electric current sensor 31a. The filter 42 is a band pass filter (BPF), and allows only an electric current in a predetermined frequency range to pass, out of the electric current that has been output from the amplifier 41. Accordingly, electric current whose frequency component includes a large amount of switching noise of a converter (DC-DC converter) of the PCS 13 can be excluded from the electric current that is output from the amplifier 41. The A/D conversion unit 43 converts an analog signal of the electric current that has passed through the filter 42 into a digital signal, and inputs the digital signal to the CPU 44.

The CPU 44 is provided with an FFT processing unit 51 and an arc existence determination unit 52. The FFT processing unit 51 performs FFT on a digital signal of an electric current that has been input from the A/D conversion unit 43, and generates a power spectrum of the electric current. The arc existence determination unit 52 determines whether or not an arc has been generated, based on the power spectrum of the electric current generated the FFT processing unit 51.

Operations of Solar Power Generation System 1 and Arc Detection Apparatus 61

Operations of the solar power generation system 1 and the arc detection apparatus 61 in the above-described configuration will be described below.

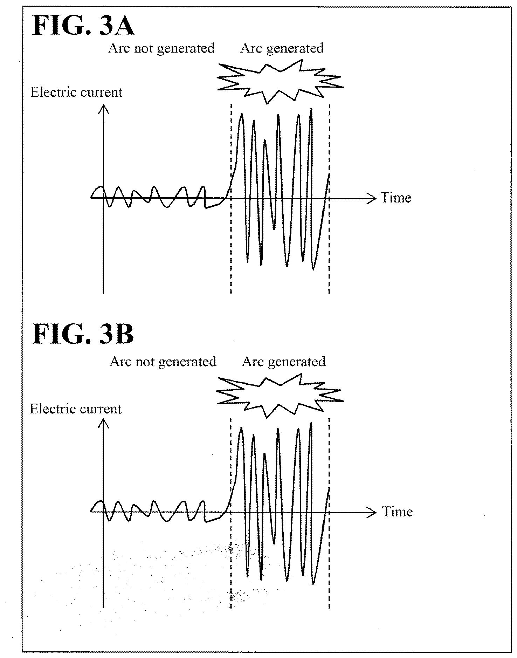

FIG. 3A is a graph showing the waveform of an alternating current in the arc non-generation state and the arc generation state at a stage before the DC-DC converter 22 (on the solar battery string 11a side). FIG. 3B is a graph showing the waveform of an alternating current in the arc non-generation state and the arc generation state at a stage behind the DC-DC converter 22 (on the PCS 13 side).

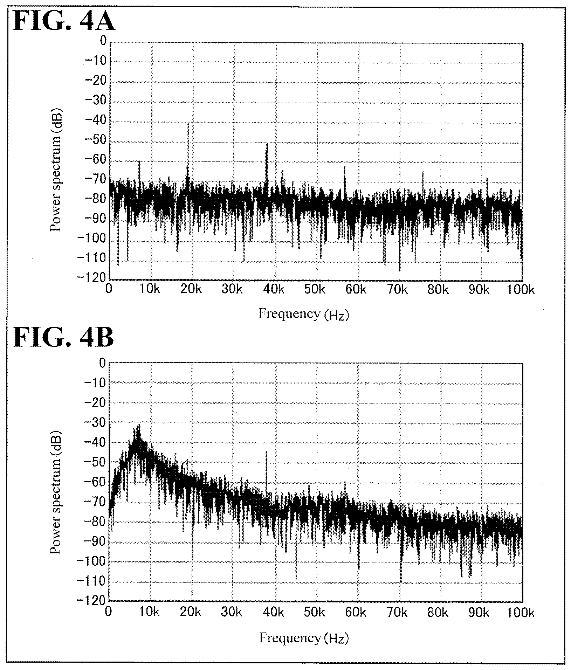

FIG. 4A is a waveform chart showing the waveform after FFT processing of an electric current measured by the electric current sensor 31a in a case where an arc has not been generated in the solar battery string 11a. FIG. 4B is a waveform chart showing the waveform after FFT processing of an electric current measured by the electric current sensor 31a in a case where an arc has been generated in the solar battery string 11a.

The solar battery string 11a generates direct current power, and the electric power generated by the solar battery string 11a is input to the PCS 13 via the DC-DC converter 22. In this case, the direct electric current that is output from the solar battery string 11a is blocked by the capacitors 19 and 20, and does not flow through the bypass current paths 23 and 24. The PCS 13 converts the direct current power that has been input via the DC-DC converter 22 into alternating current power, and outputs the alternating current power.

Here, if an arc has not been generated in the solar battery string 11a, the waveform of the alternating current upstream of the DC-DC converter 22 (on the solar battery string 11a side) will be a waveform in the arc non-generation state, which is shown in FIG. 3A. Therefore, the electric current measured by the electric current sensor 31a does not include the alternating current of an arc, and the waveform of this electric current on which the FFT processing unit 51 has performed FFT processing will be as shown in FIG. 4A.

On the other hand, if an arc has been generated in the solar battery string 11a, the waveform of the alternating current at a stage before the DC-DC converter 22 (on the solar battery string 11a side) will be the waveform in the arc generation state, which is shown in FIG. 3A. In this case, although the alternating current of the arc does not flow through the DC-DC converter 22, the alternating current flows from the power line 17a through the power line 18a via the bypass current path 23, the power line 17b, the PCS 13, the power line 18b and the bypass current path 24. Therefore, the waveform of the alternating current downstream of the DC-DC converter 22 (on the PCS 13 side) is the waveform in the arc generation state shown in FIG. 3C. In addition, the alternating current of the arc is measured by the electric current sensor 31a provided on the power line 17b.

Therefore, an electric current measured by the electric current sensor 31a includes the alternating current of the arc, and the waveform of this electric current after being FFT processed by the FFT processing unit 51 will be as shown in FIG. 4B. Accordingly, the arc detection processing unit 32 can detect generation of an arc on the solar battery string 11a based on a signal that has been input from the electric current sensor 31a.

Advantages of Arc Detection Apparatus 61

As described above, the arc detection apparatus 61 is provided with the bypass current paths 23 and 24 for the DC-DC converter 22, on the solar battery string 11a provided with the DC-DC converter 22. In addition, the capacitors 19 and 20 are respectively provided on these bypass current paths 23 and 24, and the electric current sensor 31a is provided on the power line 17b between the DC-DC converter 22 and the PCS 13. Therefore, even if there is a DC-DC converter 22 in the solar power generation system 1, the electric current sensor 31a can measure the alternating current of an arc generated in the solar battery string 11a.

Impedances of capacitors 19 and 20

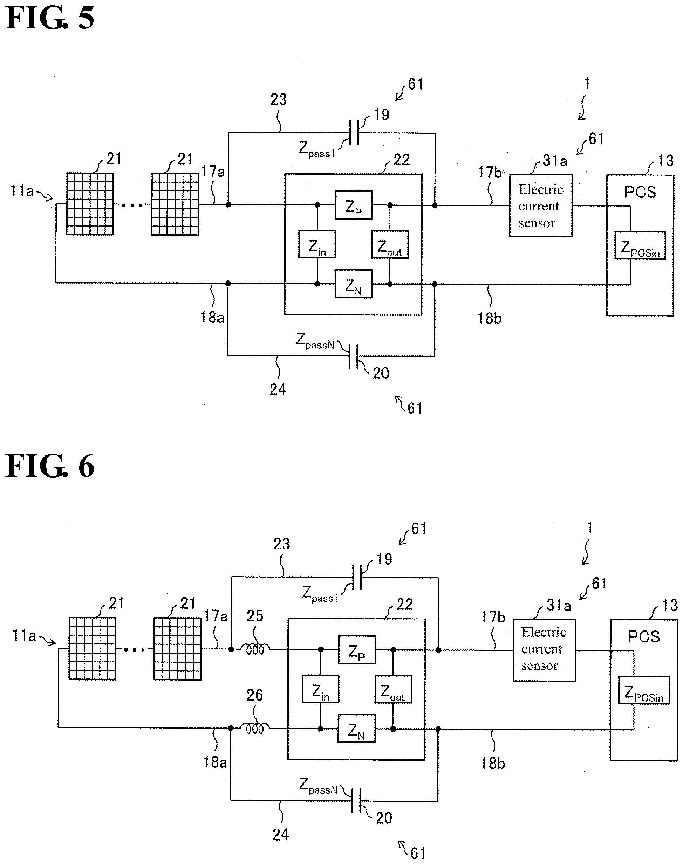

FIG. 5 is a circuit diagram similar to FIG. 1, and shows an internal impedance of the DC-DC converter 22 and an internal impedance on the input side of the PCS 13 using an equivalent circuit.

As shown in FIG. 5, the DC-DC converter 22 has an impedance $Z_{in}$ between the power lines 17a and 18a on the input side, an impedance $Z_{out}$ between the power lines 17b and 18b on the output side, an impedance Zp between the power lines 17a and 17b on the positive side, and an impedance $Z_N$ between the power lines 18a and 18b on the negative side. In addition, the PCS 13 has an impedance $Z_{PCSin}$ between the power lines 17b and 18b on the input side.

Note that other impedances in the PCS 13 are omitted. Furthermore, an impedance of the capacitor 19 is denoted by $Z_{passP}$, and an impedance of the capacitor 20 is denoted by $Z_{passN}$.

In order for the electric current sensor 31a to detect the above-described alternating current of an arc, the amount of the alternating current that flows from the power line 17a to the power line 18a via the impedance $Z_{passP}$ and the impedance Zp, then the impedance $Z_{out}$ and the impedance $Z_{PCSin}$, and the impedance $Z_{passN}$ and the impedance $Z_N$ is desirably greater than the amount of the alternating current that flows from the power line 17a to the power line 18a via the impedance $Z_{in}$. In other words, Conditional Expression 1 below is desirably satisfied.

$$(\text{combined impedance of } Z_{passP}, Z_P, Z_{out}, Z_{PCSin}, Z_{passN} \text{ and } Z_N) = \{(1 / Z_{passP}) + (1 / Z_P)\} - 1 + \{(1 / Z_{passN}) + (1 / Z_N)\} - 1 + \{(1 / Z_{out}) + (1 / Z_{PCSin})\} - 1 \le Z_{in} \ldots 1$$

In addition, in order for the electric current sensor 31a to detect such alternating current of an arc, the amount of the alternating current that flows from the power line 17b to the power line 18b via the impedance $Z_{PCSin}$ is desirably greater than the amount of the alternating current that flows through the impedance $Z_{out}$. In other words, Expression 2 below is desirably satisfied.

$$Z_{PCSin} \le Z_{out} \ldots 2$$

Therefore, for example, the impedances $Z_{in}$, $Z_{out}$, $Z_P$ and $Z_N$ in the DC-DC converter 22 and the impedance $Z_{PCSin}$ in the PCS 13 are measured using an LCR meter, and the impedances $Z_{passP}$ and $Z_{passN}$ of the capacitors 19 and 20 can be easily determined using the result of the measurement and Conditional Expression 1 above. In addition, for example, a capacitor may be provided between the power line 17b and the power line 18b on the PCS 13 side relative to the electric current sensor 31a so as to satisfy Expression 2 above, using the result of the above measurement.

Furthermore, if Conditional Expression 1 above is referenced, it can be understood that if $Z_N < Z_{in}$, the impedance $Z_{passN}$ may be any value. Therefore, if the impedance $Z_N$ is significantly smaller than the impedance $Z_{in}$, the capacitor 20 that has the impedance $Z_{passN}$ can be omitted.

Second Embodiment

FIG. 6 is a schematic circuit diagram showing the configuration of a solar power generation system provided with an arc detection apparatus according to another embodiment of the present invention. Similarly to FIG. 5, FIG. 6 shows internal impedances of a DC-DC converter 22 and an internal impedance on the input side of a PCS 13, using an equivalent circuit.

As shown in FIG. 6, a solar power generation system 1 of this embodiment is different from the solar power generation system 1 shown in FIGS. 1 to 5 in that coils 25 and 26 are newly provided on power lines 17a and 18a on the input side of the DC-DC converter 22 respectively, and other configurations are similar.

In this embodiment, a first end portion (a connection portion) of a bypass current path 23 is connected to the power line 17a between the coil 25 (a first coil) and a solar battery string 11a, and a second end portion of the bypass current path 23 is connected to a power line 17b between the DC-DC converter 22 and an electric current sensor 31a, so as to bypass the coil 25 and the DC-DC converter 22. Similarly, a first end portion of a bypass current path 24 is connected to the power line 18a between the coil 26 (a second coil) and the solar battery string 11a, and a second end portion of the bypass current path 24 is connected to a power line 18b between the DC-DC converter 22 and the PCS 13, so as to bypass the coil 26 and the DC-DC converter 22.

By adding the coils 25 and 26, the amount of the alternating current that flows from the power line 17a to the power line 18a via the coil 25, an impedance $Z_{in}$ and the coil 26 decreases. Therefore, the amount of the alternating current that flows through the bypass current paths 23 and 24 increases, and the amount of the alternating current that flows through the electric current sensor 31a increases. As a result, generation of an arc can be detected accurately.

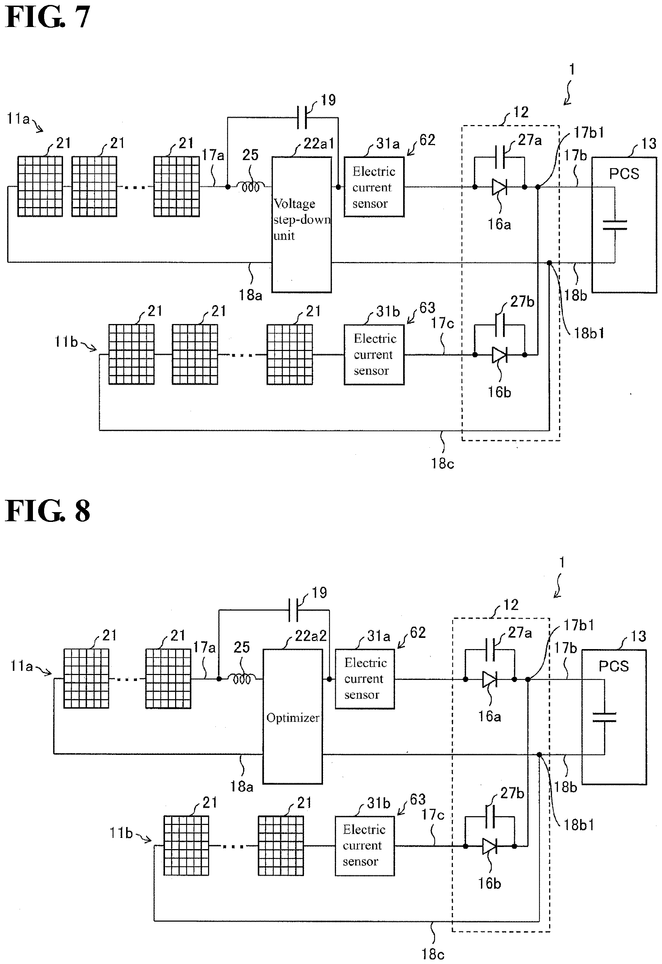

Note that the coils 25 and 26 may be incorporated in an input portion of the DC-DC converter 22. In addition, if the capacitor 20 is omitted as described above, the coil 26 may be omitted (see FIGS. 7, 8, and 11).

Third Embodiment

FIG. 7 is a schematic circuit diagram showing the configuration of a solar power generation system provided with an arc detection apparatus according to yet another embodiment of the present invention.

Configuration of Solar Power Generation System 1

As shown in FIG. 7, a solar battery string 11a is connected to a PCS 13 via a voltage step-down unit 22a1 (a DC-DC conversion circuit) and a connection box 12. A solar battery string 11b is connected to the PCS 13 via the connection box 12. The connection box 12 connects the solar battery string 11a and the solar battery string 11b (a second DC power source) in parallel.

Specifically, regarding the solar battery string 11b, a P-side power line 17c (a third power line) connected to the solar battery string 11b is connected to a P-side power line 17b at a positive branch point 17b1 on the P-side power line 17b, and an N-side power line 18c (a third power line) connected to the solar battery string 11b is connected to an N-side power line 18b at a negative branch point 18b1 on the power line 18b.

Reverse current preventing diodes 16a and 16b are provided inside the connection box 12. The reverse current preventing diode 16a is provided on the power line 17b between the voltage step-down unit 22a1 and the positive branch point 17b1, and prevents an electric current from flowing in the opposite direction to an electric current supplied by the solar battery string 11a. The reverse current preventing diode 16b is provided on the power line 17c between the solar battery string 11b and the positive branch point 17b1, and prevents an electric current from flowing in the opposite direction to an electric current supplied from the solar battery string 11b. Note that the arrangement positions of the reverse current preventing diodes 16a and 16b are not limited to on the power lines 17b and 17c, and may be on the power lines 18b and 18c. Note that if the reverse current preventing diodes 16a and 16b are arranged respectively on the power lines 18b and 18c, the reverse current preventing diodes 16a and 16b will be in the direction in which their anodes are connected to the PCS 13.

The voltage step-down unit 22a1 is a type of DC-DC converter, and steps down an output voltage of the solar battery string 11a so as to match an output voltage of the solar battery string 11b. Specifically, the number of solar battery modules 21 is different between the solar battery string 11a and the solar battery string 11b, and the number of the solar battery modules 21 of the solar battery string 11a is greater than the number of the solar battery modules 21 of the solar battery string 11b. In view of this, the voltage step-down unit 22a1 steps down the output voltage of the solar battery string 11a so as to eliminate the difference between the output voltage of the solar battery string 11a and the output voltage of the solar battery string 11b.

Note that FIG. 7 shows an example in which the two solar battery strings 11a and 11b are provided as a plurality of solar battery strings, but the solar power generation system 1 may be provided with three or more solar battery strings. This also applies to other embodiments in which a plurality of solar battery strings are provided.

Configuration of Arc Detection Apparatus

In the solar power generation system 1 of this embodiment, the solar battery strings 11a and 11b are each provided with an arc detection apparatus. An arc detection apparatus 62 provided on the solar battery string 11a includes a capacitor 19, a bypass current path 23 constituted by the capacitor 19, a coil 25, an electric current sensor 31a, an arc detection processing unit 32 and a capacitor 27a. The capacitor 27a is connected in parallel to the reverse current preventing diode 16a.

Note that the capacitor 27a being connected in parallel to the reverse current preventing diode 16a is not limited to a configuration in which the capacitor 27a is connected in parallel only to the reverse current preventing diode 16a, and also includes a configuration in which the capacitor 27a is connected in parallel to the reverse current preventing diode 16a and another circuit element connected in series to the reverse current preventing diode 16a.

An arc detection apparatus 63 provided on the solar battery string 11b is provided with an electric current sensor 31b (an electric current measurement unit), the arc detection processing unit 32 and a capacitor 27b. The electric current sensor 31b is provided on the power line 17c between the solar battery string 11b and the connection box 12, for example. The electric current sensor 31b measures an electric current that is caused by an arc generated in the solar battery string 11b and flows through the power line 17b. The capacitor 27b is connected in parallel to the reverse current preventing diode 16b. The capacitors 27a and 27b have an electrostatic capacitance of 5 $\mu$F or more, for example.

Note that the arc detection apparatuses 62 and 63 may have either a configuration in which arc detection processing units 32 are provided in correspondence with the electric current sensors 31a and 31b, or a configuration in which a single arc detection processing unit 32 processes electric currents measured by the electric current sensors 31a and 31b, in a time-division manner. The same applies to another embodiment in which two electric current sensors 31a and 31b are provided.

Operations of Arc Detection Apparatus

In the above-described configuration, operations of the arc detection apparatuses 62 and 63 will be described below. If an arc (a series arc or a parallel arc) is generated in the solar battery string 11a, the alternating current of the arc tends not to flow to the coil 25 and the voltage step-down unit 22a1, but tends to flow to the bypass current path 23 that has the capacitor 19, and is measured by the electric current sensor 31a. In addition, if an arc is generated in the solar battery string 11b, the alternating current of the arc flows through the power line 17c, and is measured by the electric current sensor 31b. Accordingly, the arc detection apparatuses 62 and 63 can detect generation of an arc on the solar battery strings 11a and 11b.

In addition, for example, if a parallel arc is generated in the solar battery string 11a, and an output voltage of the solar battery string 11a falls below an output voltage of the solar battery string 11b, there are cases where the reverse current preventing diode 16a enters a reverse bias state. When the output voltage of the solar battery string 11a falls to an extent where the voltage step-down unit 22a1 cannot exhibit its function, the reverse current preventing diode 16a is reverse-biased. On the other hand, when an output voltage of the solar battery string 11a falls in a range in which the voltage step-down unit 22a1 can exhibit its function, the reverse current preventing diode 16a is not reverse-biased.

When the reverse current preventing diode 16a enters the reverse bias state, and the capacitor 27a is not connected in parallel to the reverse current preventing diode 16a, the alternating current of the parallel arc generated in the solar battery string 11a is blocked by the reverse current preventing diode 16a. Therefore, the electric current sensor 31a cannot measure the alternating current of the parallel arc.

On the other hand, in the arc detection apparatus 62, the capacitor 27a is connected in parallel to the reverse current preventing diode 16a. Therefore, even if the reverse current preventing diode 16a is in the reverse bias state, the alternating current of the parallel arc generated in the solar battery string 11a flows via the capacitor 27a, and thus can be measured by the electric current sensor 31a. Accordingly, the arc detection apparatus 62 can detect a parallel arc generated in the solar battery string 11a.

The above operations of the arc detection apparatus 62 performed by the capacitor 27a being connected in parallel to the reverse current preventing diode 16a are similar to operations of the arc detection apparatus 63 if a parallel arc is generated in the solar battery string 11b, and the reverse current preventing diode 16b enters a reverse bias state.

The same also applies to a configuration of another embodiment in which a reverse current preventing diode is provided on a solar battery string, and a bypass capacitor has a reverse current preventing diode.

Advantages of Arc Detection Apparatuses 62 and 63

As described above, the arc detection apparatus 62 is provided with the bypass current path 23 for the voltage step-down unit 22a1, on the solar battery string 11a on which the voltage step-down unit 22a1 is provided, and the capacitor 19 is provided on this bypass current path 23. Therefore, the electric current sensor 31a can also measure the alternating current of an arc generated in the solar battery string 11a on which the voltage step-down unit 22a1 is provided.

Furthermore, the coil 25 is provided between a first end portion of the bypass current path 23 and the voltage step-down unit 22a1, and thus the amount of the alternating current that flows from the power line 17a to the voltage step-down unit 22a1 via the coil 25 decreases, while the amount of the alternating current that flows through the bypass current path 23 increases. Therefore, the amount of the alternating current that flows to the electric current sensor 31a increases, and thus an arc generated in the solar battery string 11a can be detected accurately.

Furthermore, the arc detection apparatuses 62 and 63 are provided with the capacitors 27a and 27b connected respectively in parallel to the reverse current preventing diodes 16a and16b, and thus even if the reverse current preventing diode 16a or the reverse current preventing diode 16b is in a reverse bias state, the electric current sensors 31a and 31b can measure the alternating current of a parallel arc generated in the solar battery string 11a and the alternating current of a parallel arc generated in the solar battery string 11b, respectively. Accordingly, a parallel arc generated in the solar battery strings 11a and 11b can be detected.

Fourth Embodiment

FIG. 8 is a schematic circuit diagram showing the configuration of a solar power generation system provided with an arc detection apparatus according to yet another embodiment of the present invention. A solar power generation system 1 of this embodiment is different from the solar power generation system 1 shown in FIG. 7 in that an optimizer 22a2 (a DC-DC conversion circuit) is provided in place of the voltage step-down unit 22a1, and other configurations are similar.

The optimizer 22a2 is a type of a DC-DC converter, and optimizes electric power from a solar battery string 11a, and supplies the optimized electric power to power lines 17b and 18b. This makes it possible to improve the output efficiency of electric power from the solar battery string 11a to a PCS 13.

Also in the solar power generation system 1 of this embodiment, it is possible to provide an effect similar to that of the solar power generation system 1 shown in FIG. 7.

Fifth Embodiment

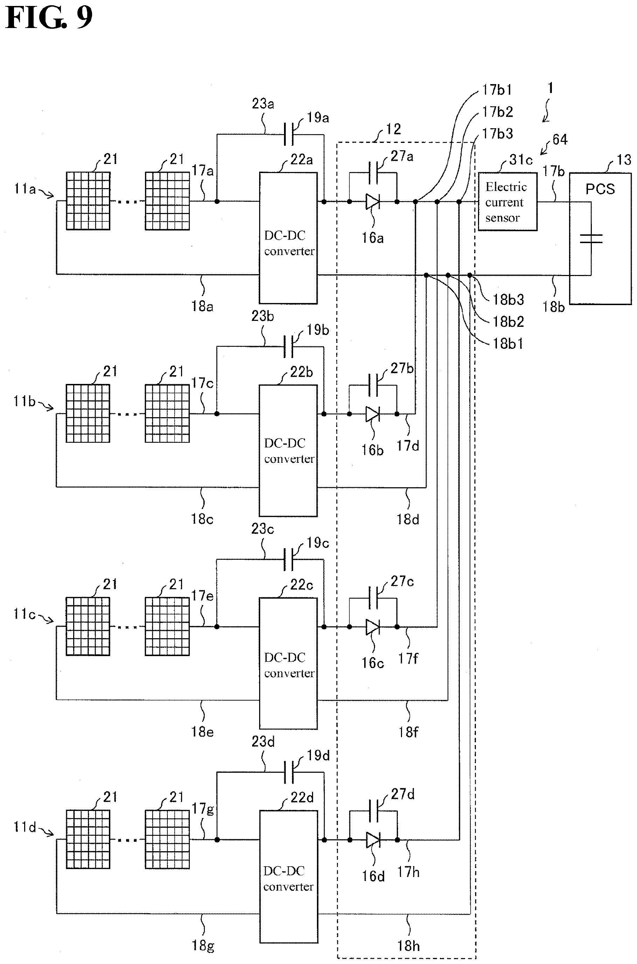

FIG. 9 is a schematic circuit diagram showing the configuration of a solar power generation system provided with an arc detection apparatus according to yet another embodiment of the present invention.

Configuration of Solar Power Generation system 1

As shown in FIG. 9, a solar power generation system 1 is provided with four solar battery strings 11a to 11d (first DC power sources and second DC power sources), four DC-DC converters 22a to 22d (DC-DC conversion circuits), a connection box 12 and a PCS 13. Note that the number of solar battery strings of the solar power generation system 1 may be two or three, and may be five or more.

The solar battery strings 11a to 11d are connected to the connection box 12 via the DC-DC converters 22a to 22d respectively, and the connection box 12 is connected to the PCS 13. The connection box 12 connects the four solar battery strings 11a to 11d in parallel.

Four reverse current preventing diodes 16a to 16d are provided inside the connection box 12. The reverse current preventing diode 16a is provided on a power line 17b between the DC-DC converter 22a and a positive branch point 17b1. The reverse current preventing diodes 16b to 16d are respectively provided on power lines 17d, 17f and 17h (third power lines) between the DC-DC converters 22b to 22d and positive branch points 17b1 to 17b3, respectively. The reverse current preventing diodes 16a to 16d prevent an electric current from flowing in an opposite direction to an electric current supplied by the solar battery strings 11a to 11d, respectively.

Note that the reverse current preventing diodes 16a to 16d may be respectively arranged on power lines 18b, 18d, 18f and 18h (third power lines) in place of the power lines 17b, 17d, 17f and 17h. In this case, the reverse current preventing diodes 16a to 16d will be in the direction in which their anodes are connected to the PCS 13.

Configuration of Arc Detection Apparatus

The solar power generation system 1 of this embodiment is provided with an arc detection apparatus 64 in place of the arc detection apparatuses 62 and 63 shown in FIGS. 7 and 8. As shown in FIG. 9, the arc detection apparatus 64 is provided with capacitors 19a to 19d (first capacitors), bypass current paths 23a to 23d respectively constituted by the capacitors 19a to 19d, capacitors 27a to 27d, an electric current sensor 31c (an electric current measurement unit), and an arc detection processing unit 32.

First end portions of the bypass current paths 23a to 23d are respectively connected to power lines 17a, 17c, 17e and 17g between the DC-DC converters 22a to 22d and the solar battery strings 11a to 11d, and second end portions of the bypass current paths 23a to 23d are respectively connected to the power lines 17b, 17d, 17f and 17h between the DC-DC converters 22a to 22d and the connection box 12, so as to bypass the DC-DC converters 22a to 22d. The capacitors 27a to 27d are connected in parallel to the reverse current preventing diodes 16a to 16d, respectively.

Note that the capacitor 27a being connected in parallel to the reverse current preventing diode 16a is not limited to a configuration in which the capacitor 27a is connected in parallel only to the reverse current preventing diode 16a, and includes a configuration in which the capacitor 27a is connected in parallel to the reverse current preventing diode 16a and another circuit element connected in series to the reverse current preventing diode 16a. The same applies to a configuration in which other capacitors, namely, the capacitors 27b to 27d, are respectively connected to other reverse current preventing diodes, namely, the reverse current preventing diodes 16b to 16d.

The electric current sensor 31c is provided on the power line 17b between the connection box 12 (a positive branch point 17b3) and the PCS 13. Note that the electric current sensor 31c may be provided on the power line 18b between the connection box 12 (a negative branch point 18b3) and the PCS 13.

Operations of Arc Detection Apparatus

In the above-described configuration, operations of the arc detection apparatus 61 will be described below. If an arc (a series arc or a parallel arc) is generated in one of the solar battery strings 11a to 11d, the alternating current of the arc tends not to flow to the DC-DC converters 22a to 22d, but tends to flow to the bypass current paths 23a to 23d that have the capacitors 19a to 19d.

In addition, even if a parallel arc is generated in one of the solar battery strings 11a to 11d, and one of the reverse current preventing diodes 16a to 16d enters a reverse bias state, the capacitors 27a to 27d are respectively connected in parallel to the reverse current preventing diodes 16a to 16d, and thus the alternating current of the parallel arc flows through the capacitors 27a to 27d.

Therefore, the electric current sensor 31c can measure the alternating current of an arc generated in one of the solar battery strings 11a to 11d, and as a result, the arc detection apparatus 64 can detect generation of such an arc.

Advantages of Arc Detection Apparatus

As described above, the arc detection apparatus 64 can detect generation of an arc on one of the solar battery strings 11a to 11d, using a simple configuration in which the electric current sensor 31c is provided on the power line 17b between the connection box 12 and the PCS 13.

In addition, in the solar power generation system 1 shown in FIGS. 7 and 8, if a parallel arc is generated between the electric current sensor 31a and the connection box 12, a high frequency component of an electric current caused by the parallel arc flows on the PCS 13 side on which an impedance is lower than on the solar battery string 11a, and thus there is a problem in that it is difficult to detect a parallel arc. Similarly, if a parallel arc is generated between the electric current sensor 31b and the connection box 12, a high frequency component of an electric current caused by the parallel arc flows on the PCS 13 side on which an AC impedance is lower than on the solar battery string 11b, and thus there is also a problem in that it is difficult to detect the parallel arc. However, in this embodiment, the electric current sensor 31c is connected on the PCS 13 side, and thus the above-described problem can be solved.

Note that for example, if the electric current sensors 31a and 31b are arranged respectively on the solar battery strings 11a and 11b as the configurations shown in FIGS. 7 and 8, it is sufficient, in order to be able to solve the above-described issue, that the electric current sensor 31a is arranged on the power line 17b downstream of the reverse current preventing diode 16a and the capacitor 27a and upstream of the positive branch point 17b1, and that the electric current sensor 31b is arranged on the power line 17c downstream of the reverse current preventing diode 16b and the capacitor 27b, and upstream of the positive branch point 17b1.

Sixth Embodiment

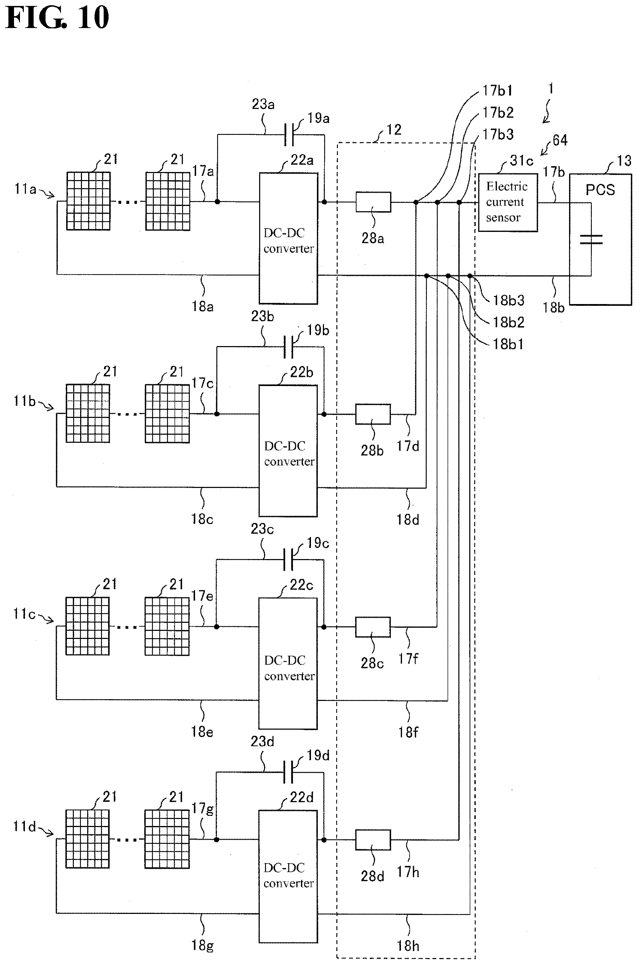

FIG. 10 is a schematic circuit diagram showing the configuration of a solar power generation system provided with an arc detection apparatus according to yet another embodiment of the present invention. A solar power generation system 1 of this embodiment is different from the solar power generation system 1 shown in FIG. 9 in that fuses 28a to 28d are provided respectively in place of the reverse current preventing diodes 16a to 16d, and that the capacitors 27a to 27d are omitted, and other configurations are similar.

The fuses 28a to 28d break the circuit when an overcurrent flows. An alternating current flows in the fuses 28a to 28d, and thus even if the capacitors 27a to 27d are omitted, an arc detection apparatus 64 can detect generation of an arc on solar battery strings 11a to 11d.

In addition, for example, if a parallel arc is generated in the solar battery string 11a, and an output voltage of the solar battery string 11a falls below output voltages of the solar battery string 11b to 11d, there are cases where the fuse 28a enters a reverse bias state. In this case, a large current flows from the solar battery strings 11b to 11d to the fuse 28a via DC-DC converters 22b to 22d, and the fuse 28a breaks the circuit. Accordingly, it is possible to prevent damage to the solar battery string 11a and the DC-DC converter 22a. In addition, the arc detection apparatus 64 can determine that a malfunction of some type has occurred in the solar power generation system 1 by an electric current sensor 31c detecting a change in the electric current when the fuse 28a breaks the circuit.

Seventh Embodiment

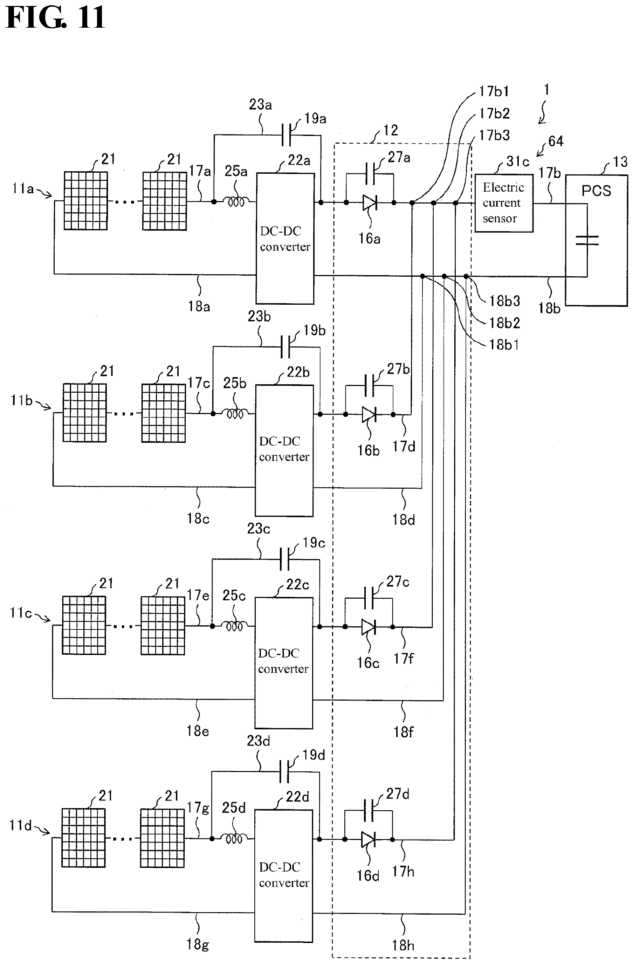

FIG. 11 is a schematic circuit diagram showing the configuration of a solar power generation system provided with an arc detection apparatus according to another embodiment of the present invention. A solar power generation system 1 of this embodiment is different from the solar power generation system 1 shown in FIG. 9 in that coils 25a to 25d (first coils) are respectively newly provided on power lines 17a, 17c, 17e and 17g on the input side of DC-DC converters 22a to 22d, and other configurations are similar.

In this embodiment, first end portions of bypass current paths 23a to 23d are respectively connected to the power lines 17a, 17c, 17e and 17g between the coils 25a to 25d and solar battery strings 11a to 11d, and second end portions of the bypass current paths 23a to 23d are connected to power lines 17b, 17d, 17f and 17h between the DC-DC converters 22a to 22d and a connection box 12, so as to bypass the coils 25a to 25d and the DC-DC converters 22a to 22d.

By adding the coils 25a to 25d, as described above, the amounts of the alternating current that flow through the bypass current paths 23a to 23d increase, and the amount of the alternating current that flows through the electric current sensor 31a increases. As a result, generation of an arc can be detected accurately. Note that the coils 25a to 25d may be respectively incorporated in the DC-DC converters 22a to 22d.

Supplementary Information

Note that in the above embodiments, the present invention is applied to a solar power generation system, but there is no limitation thereto, and the present invention can be applied to any power supply system provided with a DC power source. Examples of such a DC power source include a fuel cell apparatus that can acquire electrical energy (direct current power) by electrochemical reaction between hydrogen fuel and oxygen in the air using hydrogen fuel, a storage battery for accumulating electrical energy, an electricity storage device such as a capacitor, and the like, in addition to a solar power generation apparatus.

The present invention is not limited to the above-described embodiments, and various modifications can be made thereto within the scope laid out in the claims. Embodiments achieved by combining the technical means disclosed in different embodiments as appropriate also fall within the technical scope of the present invention.

## Claims

1.  An arc detection apparatus (61) that is applied to a DC power system (1), the DC power system (1) including:

    a first DC power source (11a) that generates electric power or performs charging/ discharging;
    a DC-DC conversion circuit (22) that converts an output voltage of the first DC power source (11a);
    a load apparatus (13) that consumes or converts an output power of the DC-DC conversion circuit (22);
    a pair of first power lines (17a, 18a) that connect the first DC power source (11a) and the DC-DC conversion circuit (22); and
    a pair of second power lines (17b, 18b) that connect the DC-DC conversion circuit (22) and the load apparatus (13),
    **characterized in that**
    the arc detection apparatus (61) comprises:

    a first capacitor (19) whose one end portion is connected to one of the pair of first power lines (17a), and whose other end portion is connected to one of the pair of second power lines (17b);
    an electric current measurement unit (31a) that measures an electric current in the second power lines (17b, 18b); and
    an arc determination unit (32) that determines whether or not an arc is generated based on a high frequency component of an alternating current measured by the electric current measurement unit (31a),
    wherein an impedance of the first capacitor (19) satisfies a condition that a combined impedance of the impedance of the first capacitor (19), impedances of the DC-DC conversion circuit (22) between the pair of first power lines (17a, 18a) and the pair of second power lines (17b, 18b), an impedance of the DC-DC conversion circuit (22) between the pair of second power lines (17b, 18b), and an impedance of the load apparatus (13) is smaller than an impedance of the DC-DC conversion circuit (22) between the pair of first power lines (17a, 18a).

2.  The arc detection apparatus according to claim 1, further comprising
    a first coil (25) provided between a connection portion on the first power line (17a) connecting to the first capacitor (19) and an input portion of the DC-DC conversion circuit (22).

3.  The arc detection apparatus according to claim 1 or 2, further comprising
    a second capacitor (20) whose one end portion is connected to the other of the pair of first power lines (18a), and whose other end portion is connected to the other of the pair of second power lines (18b),
    wherein impedances of the first capacitor (19) and the second capacitor (20) satisfy a condition that a combined impedance of the impedances of the first capacitor (19) and the second capacitor (20), the impedances of the DC-DC conversion circuit (22) between the pair of first power lines (17a, 18a) and the pair of second power lines (17b, 18b), the impedance of the DC-DC conversion circuit (22) between the pair of second power lines (17b, 18b), and the impedance of the load apparatus (13) is smaller than the impedance of the DC-DC conversion circuit (22) between the pair of first power lines (17a, 18a).

4.  The arc detection apparatus according to claim 3, further comprising
    a second coil (26) provided between a connection portion on the first power line (18a) connecting to the second capacitor (20) and the input portion of the DC-DC conversion circuit (22).

5.  The arc detection apparatus according to any one of claims 1 to 4,
    wherein the DC power system (1) to which the arc detection apparatus (61) is applied further includes:

a second DC power source (11b) that generates electric power or performs charging/discharging; and

a pair of third power lines (17d, 18d) that connect the second DC power source (11b) and the pair of second power lines (17b, 18b), and

the electric current measurement unit (31c) is provided between the load apparatus (13) and one of branch points at which the pair of second power lines (17b. 18b) and the pair of third power lines (17d, 18d) are connected.


**Patentansprüche**

1.  Bogenerkennungsvorrichtung (61), angewandt in einem Gleichstromsystem (1), wobei das Gleichstromsystem (1) aufweist:

    eine erste Gleichstromquelle (11a), die elektrische Leistung erzeugt oder ein Laden/Entladen durchführt;
    eine Gleichstromwandlungsschaltung (22), die eine Ausgangsspannung der ersten Gleichstromquelle (11a) wandelt;
    eine Lastvorrichtung (13), die eine Ausgangsleistung der Gleichstromwandlungsschaltung (22) aufnimmt oder wandelt;
    zwei erste Stromleitungen (17a, 18a), welche die erste Gleichstromquelle (11a) und die Gleichstromwandlungsschaltung (22) verbinden; und
    zwei zweite Stromleitungen (17b, 18b), welche die Gleichstromwandlungsschaltung (22) und die Lastvorrichtung 813) verbinden,
    **dadurch gekennzeichnet, dass**
    die Bogenerkennungsvorrichtung (61) umfasst:

    einen ersten Kondensator (19), dessen einer Endabschnitt mit einer der zwei ersten Stromleitungen (17a) verbunden ist, und dessen anderer Endabschnitt mit einer der zwei zweiten Stromleitungen (17b, 18b) verbunden ist;
    eine Strommesseinheit (31a), welche einen elektrischen Strom in den zweiten Stromleitungen (17b, 18b) misst;
    eine Bogenbestimmungseinheit (32), die basierend auf einer Hochfrequenzkomponente eines von der Strommesseinheit (31a) gemessenen Wechselstroms bestimmt, ob ein Bogen erzeugt wird oder nicht,
    wobei eine Impedanz des ersten Kondensators (19) eine Bedingung erfüllt, dass eine kombinierte Impedanz aus der Impedanz des ersten Kondensators (19), Impedanzen der Gleichstromwandlungsschaltung (22) zwischen den zwei ersten Stromleitungen (17a, 18a) und dem Paar zweiter Stromleitungen (17b, 18b), einer Impedanz der Gleichstromwandlungsschaltung (22) zwischen dem Paar zweiter Stromleitungen (17b, 18b) und einer Impedanz der Lastvorrichtung (13) kleiner ist als eine Impedanz der Gleichstromwandlungsschaltung (22) zwischen den zwei ersten Stromleitungen (17a, 18a).

2.  Bogenerkennungsvorrichtung nach Anspruch 1, ferner umfassend:
    eine erste Spule (25), die zwischen einem Verbindungsabschnitt an der ersten Stromleitung (17a), die mit dem ersten Kondensator (19) verbunden ist, und einem Eingangsabschnitt der Gleichstromwandlungsschaltung (22) bereitgestellt ist.

3.  Bogenerkennungsvorrichtung nach Anspruch 1 oder 2, ferner umfassend:

    einen zweiten Kondensator (20), dessen einer Endabschnitt mit der anderen der beiden ersten Stromleitungen (18a) verbunden ist, und dessen anderer Endabschnitt mit der anderen der beiden zweiten Stromleitungen (18b) verbunden ist,
    wobei Impedanzen des ersten Kondensators (19) und des zweiten Kondensators (20) eine Bedingung erfüllen, dass eine kombinierte Impedanz der Impedanzen des ersten Kondensators (19) und des zweiten Kondensators (20), der Impedanzen der Gleichstromwandlungsschaltung (22) zwischen den zwei ersten Stromleitungen (17a, 18a) und den zwei zweiten Stromleitungen (17b, 18b), der Impedanz der Gleichstromwandlungsschaltung (22) zwischen den zwei zweiten Stromleitungen (17b, 18b) und der Impedanz der Lastvorrichtung (13) kleiner ist als die Impedanz der Gleichstromwandlungsschaltung (22) zwischen den beiden ersten Stromleitungen (17a, 18a).

4.  Bogenerkennungsvorrichtung nach Anspruch 3, ferner umfassend:
    eine zweite Spule (26), die zwischen einem Verbindungsabschnitt in der ersten Stromleitung (18a), der mit dem zweiten Kondensator (20) verbunden ist, und dem Eingangsabschnitt der Gleichstromwandlungsschaltung (22) bereitgestellt ist.

5. Bogenerkennungsvorrichtung nach einem der Ansprüche 1 bis 4,
wobei das Gleichstromsystem (1), in welchem die Bogenerkennungsvorrichtung (61) angewandt ist, ferner aufweist:

eine zweite Gleichstromquelle (11b), die elektrische Leistung erzeugt oder ein Laden/Entladen durchführt; und
zwei dritte Stromleitungen (17d, 18d), welche die zweite Gleichstromquelle (11b) und die zwei zweiten Stromleitungen (17b, 18b) verbinden, und
die Strommesseinheit (31c) zwischen der Lastvorrichtung (13) und einem von Verzweigungspunkten bereitgestellt ist, an denen die zwei zweiten Stromleitungen (17b, 18b) und die zwei dritten Stromleitungen (17d, 18d) verbunden sind.

**Revendications**

1. Appareil de détection d'arc (61) qui est appliqué à un système d'alimentation c.c. (1),
le système d'alimentation c.c. (1) comprenant :

une première source d'alimentation c.c. (11a) qui génère de la puissance électrique ou effectue une charge/décharge ;
un circuit de conversion c.c.-c.c. (22) qui convertit une tension de sortie de la première source d'alimentation c.c. (11a) ;
un appareil de charge (13) qui consomme ou convertit une puissance de sortie du circuit de conversion c.c.-c.c. (22) ;
deux premières lignes d'alimentation (17a, 18a) qui connectent la première source d'alimentation c.c. (11a) et le circuit de conversion c.c.-c.c. (22) ; et
deux deuxièmes lignes d'alimentation (17b, 18b) qui connectent le circuit de conversion c.c.-c.c. (22) et l'appareil de charge (13), **caractérisé en ce que**
l'appareil de détection d'arc (61) comprend :

un premier condensateur (10) dont une partie d'extrémité est connectée à l'une des deux premières lignes d'alimentation (17a), et dont l'autre partie d'extrémité est connectée à l'une des deux deuxièmes lignes d'alimentation (17b) ;
une unité de mesure de courant électrique (31a) qui mesure un courant électrique circulant dans les deuxièmes lignes d'alimentation (17b, 18b) ; et
une unité de détermination d'arc (32) qui détermine si un arc est, ou non, généré sur la base d'une composante haute fréquence d'un courant alternatif mesuré par l'unité de mesure de courant électrique (31a), dans lequel une impédance du premier condensateur (19) satisfait une condition telle qu'une impédance combinée de l'impédance du premier condensateur (19), d'impédances du circuit de conversion c.c.-c.c. (22) entre les deux premières lignes d'alimentation (17a, 18a) et les deux deuxièmes lignes d'alimentation (17b, 18b), d'une impédance du circuit de conversion c.c.-c.c. (22) entre les deux deuxièmes lignes d'alimentation (17b, 18b) et d'une impédance de l'appareil de charge (13) est inférieure à une impédance du circuit de conversion c.c.-c.c. (22) entre les deux premières lignes d'alimentation (17a, 18a).

2. Appareil de détection d'arc selon la revendication 1, comprenant en outre
une première bobine (25) disposée entre une partie de connexion de la première ligne d'alimentation (17a) connectant le premier condensateur (19) et une partie d'entrée du circuit de conversion c.c.-c.c. (22).

3. Appareil de détection d'arc selon la revendication 1 ou la revendication 2, comprenant en outre
un second condensateur (20) dont une partie d'extrémité est connectée à l'autre des deux premières lignes d'alimentation (18a), et dont l'autre partie d'extrémité est connectée à l'autre des deux deuxièmes lignes d'alimentation (18b),
dans lequel des impédances du premier condensateur (19) et du second condensateur (20) satisfont une condition telle qu'une impédance combinée des impédances du premier condensateur (19) et du second condensateur (20), des impédances du circuit de conversion c.c.-c.c. (22) entre les deux premières lignes d'alimentation (17a, 18a) et les deux deuxièmes lignes d'alimentation (17b, 18b), de l'impédance du circuit de conversion c.c.-c.c. (22) entre les deux deuxièmes lignes d'alimentation (17b, 18b) et de l'impédance de l'appareil de charge (13) est inférieure à l'impédance du circuit de conversion c.c.-c.c. (22) entre les deux premières lignes d'alimentation (17a, 18a).

4. Appareil de détection d'arc selon la revendication 3, comprenant en outre
une seconde bobine (26) disposée entre une partie de connexion sur la première ligne d'alimentation (18a) connectant le second condensateur (20) et la partie d'entrée du circuit de conversion c.c.-c.c. (22).

5. Appareil de détection d'arc selon l'une quelconque des revendications 1 à 4,
dans lequel le système d'alimentation c.c. (1) auquel est appliqué l'appareil de détection d'arc (61) comprend en outre :

une seconde source d'alimentation c.c. (11b) qui génère de la puissance électrique ou effectue une charge/décharge ; et
deux troisièmes lignes d'alimentation (17d ,18d) qui connectent la seconde source d'alimentation c.c. (11b) et les deux deuxièmes lignes d'alimentation (17b, 18b), et
l'unité de mesure de courant électrique (31c) est disposée entre l'appareil de charge (13) et l'un de points de branchement au niveau duquel sont connectées les deux deuxièmes lignes d'alimentation (17b, 18b) et les deux troisièmes lignes d'alimentation (17d, 18d).

# FIG. 1

# FIG. 2

# FIG. 3A

Arc not generated    Arc generated

Electric current

Time

# FIG. 3B

Arc not generated    Arc generated

Electric current

Time

FIG. 4A

FIG. 4B

# FIG. 5

# FIG. 6

# FIG. 7

# FIG. 8

# FIG. 9

## FIG. 10

# FIG. 11

# FIG. 12

# FIG. 13A

Arc not generated    Arc generated

Electric current

Time

# FIG. 13B

Arc not generated    Arc generated

Electric current

Time

**EP 3 352 315 B1**

**REFERENCES CITED IN THE DESCRIPTION**

**Patent documents cited in the description**

- JP 2017009506 A
- JP 2014509396 T
- JP 03562118 B